# FASCICULE DE BREVET EUROPEEN

(11) **EP 0 347 321 B1**
(45) Date de publication et mention de la délivrance du brevet: **05.01.1994**
(21) Numéro de dépôt: 89401677.3
(22) Date de dépôt: 15.06.1989
(51) Int. Cl.: H01L 23/60, G06K 19/067

(54) **Carte à puce avec écran de protection**
Chipkarte mit Schutzschicht
Chip card with a protection layer

(30) Priorité: 17.06.1988 FR 8808113
(43) Date de publication de la demande: 20.12.1989
(73) Titulaire: SGS-THOMSON MICROELECTRONICS S.A., 94250 Gentilly (FR)
(72) Inventeur: Deveaud, Vincent, F-75116 Paris (FR); Canella, Christophe, F-75116 Paris (FR)
(74) Mandataire: Ballot, Paul Denis Jacques

(56) Documents cités:
- EP-A- 0 037 760
- EP-A- 0 080 233
- DE-A- 2 713 936
- FR-A- 2 143 097
- FR-A- 2 370 403
- PATENT ABSTRACTS OF JAPAN, vol. 10, no. 16 (E-375)[2073], 22 janvier 1986, page 137 E 375; & JP-A-60 178 646

## Description

L'invention concerne les cartes portatives contenant des circuits-intégrés, plus généralement connues sous le nom de cartes à puces.

Les puces de circuit intégré sont montées dans des modules et encartées dans un support électriquement isolant ayant généralement le format d'une carte de crédit pour pouvoir être facilement transportée, conservée dans un portefeuille, rangée dans un étui plat etc.

Un module est composé d'une ou plusieurs puces de circuit-intégré telles que des mémoires mortes ou vives, microprocesseurs, circuits logiques ou analogiques, ou combinaison de ces circuits. Les puces sont montées par soudage ou collage sur un support comprenant des pistes conductrices reliées à des plots de contact d'entrée-sortie et d'alimentation des puces.

Les pistes conductrices sont reliées à des contacts destinés à être accessibles de l'extérieur et assurant la liaison entre les circuits-intégrés du module et les organes destinés à dialoguer avec eux. Dans le cas de cartes sans contacts, ces pistes sont reliées à des générateurs ou récepteurs d'ondes électromagnétiques assurant la liaison avec l'extérieur.

On dépose sur les circuits-intégrés une goutte de résine, ou de manière plus générale une couche de matière isolante destinée à assurer une protection des circuits contre les agressions chimiques et éventuellement mécaniques.

L'ensemble circuit-intégré et support, et le cas échéant les émetteurs et récepteurs électromagnétiques forment le module qui est inséré dans un matériau isolant en forme de carte.

Les circuits intégrés utilisés dans ces cartes sont destinés à mémoriser, protéger et éventuellement faire des calculs sur des informations provenant de l'extérieur et/ou de l'intérieur des circuits. Ils sont réalisés souvent en technologie MOS (Métal Oxyde Semiconducteur) ou CMOS (MOS complémentaires). Ils sont composés essentiellement à partir de transistors.

Les transistors sont composés d'un drain, d'une grille et d'une source, et caractérisés principalement par leurs dimensions et leur tension de seuil, tension au delà ou en deçà de laquelle le transistor est conducteur ou bloqué.

Les tensions de seuil sont fixées entre autres par le dosage et la profondeur auxquels sont placées les impuretés dans les zones actives du transistor.

Chaque transistor dans le circuit-intégré a été défini en termes de dimension et de tension de seuil de manière à assurer le bon fonctionnement du circuit-intégré. Toute variation de ces paramètres peut entraîner un non-fonctionnement de l'ensemble si cette variation est supérieure aux tolérances définies lors de la conception du circuit.

Or un champ électrique important dans l'environnement du circuit-intégré risque de modifier le nombre, la densité ou la répartition des charges électriques dans les zones actives des transistors, dans une mesure suffisante pour modifier la tension de seuil des transistors de manière non négligeable.

Une carte à puce étant formée d'un matériau isolant (typiquement du chlorure de polyvinyl), le support du module et sa résine protectrice étant également isolants, il est possible de charger électrostatiquement par frottement ou par influence les cartes donc les couches isolantes dont certaines sont à proximité immédiate de la surface des puces de circuit-intégré.

Cela est d'autant plus vrai que les cartes à puces sont généralement destinées à être manipulées par le grand public sans précautions excessives: les cartes sont prises dans les mains, rangées dans des portefeuilles ou des poches de vêtements, frottées contre les vêtements, etc.

Si les charges électrostatiques accumulées sont telles qu'un potentiel électrostatique de quelques centaines à quelques milliers de volts soit engendré à la surface d'une de ces couches isolantes, et si cette couche est distante des zones actives de quelques micromètres, il peut alors en résulter un champ électrique de l'ordre du mégavolt par centimètre, suffisant pour décaler la tension de seuil des transistors et perturber leur fonctionnement ainsi que le fonctionnement global du circuit-intégré.

Jusqu'à maintenant on s'est préoccupé de protéger les circuits-intégrés contenus dans les cartes à puces contre les décharges électrostatiques qui risquent de se produire entre les plots de circuit-intégré et de détruire les composants du circuit. La présente invention se préoccupe non pas de ce risque de destruction par claquage mais du risque de mauvais fonctionnement par modification des tensions de seuil des transistors en dehors des limites fixées par les tolérances à la conception du circuit.

Il est connu de l'état de la technique de réaliser un volume conducteur équipotentiel pour protéger une carte (EP-A-0 037 760). On connaît aussi la réalisation d'une couche conductrice placée à la surface d'un film de passivation (PATENT ABSTRACTS OF JAPAN, vol. 10, n° 16 (E-375) [2073]).

Selon l'invention, telle que définie par la revendication 1, pour restreindre la création de champs électrostatiques susceptibles de modifier la tension de seuil des transistors et donc de perturber les circuits d'une carte à puce, on propose de recouvrir la puce d'un film mince d'une substance conductrice de l'électricité, relié électriquement à une borne de circuit destinée à être connectée à un potentiel électrique de référence.

Ce film ne recouvre pas des éléments d'antenne d'émission ou de réception d'ondes électromagnétiques dans le cas où la carte fonctionne avec transmission d'énergie ou d'informations sans contacts.

Selon l'invention, on utilise comme film écran électrostatique un film métallique extrêmement mince, de quelques nanomètres (dizaines d'angströms) d'épaisseur. L'épaisseur est choisie, compte-tenu de la conductivité propre du métal choisi et compte-tenu de la distance entre plots de contact du circuit-intégré, pour que la résistance présentée par cette couche entre deux plots de contact soit comprise entre 10⁷ ohms et 10¹⁴ ohms environ; elle est alors assez résistante pour éviter des fuites de courant gênantes entre plots, mais assez conductrice pour permettre de jouer le rôle d'écran électrostatique.

Dans ce cas, il suffit de procéder de la manière suivante : on dépose la couche de passivation au-dessus de la couche d'interconnexion comprenant les interconnexions et les plots de contact du circuit-intégré, on grave la couche de passivation de manière à l'ouvrir au-dessus des plots de contact d'une manière tout-à-fait classique; puis, on dépose le film mince métallique de quelques nanomètres (dizaines d'angströms) d'épaisseur ou même moins. Ce film n'est pas gravé; il est par exemple réalisé dans le même métal que la couche d'interconnexion (dont l'épaisseur est naturellement beaucoup plus épaisse: 1 micron environ ou plus. Il ne gêne pas la prise de contact avec des fils ou rubans d'interconnexion. Il joue le rôle d'écran électrostatique car il est porté à un potentiel qui est compris entre les potentiels d'alimentation haut et bas du circuit-intégré (par exemple 0 volt et 5 volts). Il évacue les charges électrostatiques qui pourraient être engendrées à proximité de la surface supérieure de la puce. Enfin, il est suffisamment résistif dans la direction latérale (compte-tenu de la distance entre deux plots qui est de l'ordre de plusieurs centaines de micromètres) pour ne pas laisser un courant appréciable fuir entre les différents plots de contact.

Le circuit-intégré est alors soudé à un circuit imprimé par des fils de liaison ou des rubans découpés par photogravure; il est ensuite enrobé soit d'un film protecteur isolant assurant la protection contre les agents chimiques, soit d'une goutte de résine isolante assurant une protection contre les agressions chimiques et mécaniques. Le module protégé par ce film ou cette goutte de résine est alors mis en carte.

## Revendications

1. Carte à puce contenant au moins une puce de circuit-intégré, qui comporte sur l'une de ses faces une couche métallique d'interconnexion comprenant des interconnexions et des plots de contacts, une couche isolante de passivation ayant des ouvertures au-dessus desdits plots de contact, et un film mince d'une substance conductrice de l'électricité recouvrant directement la couche de passivation, étant en contact avec au moins un des plots de contacts et étant porté à un potentiel d'alimentation de la puce, caractérisée en ce que ledit film a une épaisseur de l'ordre de quelques nanomètres ou moins, en ce que le film est en contact avec l'ensemble des plots de contact, et en ce que le film présente une résistance de l'ordre de 10⁷ à 10¹⁴ ohms entre deux plots de contact de la puce.

2. Carte à puce selon la revendication 1, caractérisée en ce que des fils de liaison sont soudés sur des plots de contact de la puce par l'intermédiaire dudit film, et en ce que la puce est enrobée d'une couche isolante de protection.

3. Carte à puce selon l'une des revendications 1 ou 2, caractérisée en ce que le film ne recouvre pas des éléments d'antenne d'émission ou de réception d'ondes électromagnétiques dans le cas où la carte fonctionne avec transmission d'énergie ou d'informations sans contacts.

## Claims

1. Smart card containing at least one integrated-circuit chip, which has, on one of its faces, a metal connection layer comprising connections and contact pins, an insulating passivation layer having openings above the said contact pins, and a thin film of an electrically conductive substance directly covering the passivation layer, being in contact with at least one of the contact pins and being put at a supply potential of the chip , characterised in that the said film has a thickness of the order of a few nanometres or less, in that the film is in contact with all the contact pins, and in that the film has a resistance of around 10⁷ to 10¹⁴ ohms between two contact pins on the chip.

2. Smart card according to Claim 1, characterised in that connecting wires are soldered to contact pins on the chip by means of the said film, and in that the chip is coated with an insulating protective layer.

3. Smart card according to one of Claims 1 or 2, characterised in that the film does not cover antenna parts for transmitting or receiving electromagnetic waves where the card functions with the transmission of energy or data without contacts.

## Patentansprüche

1. Chipkarte, die wenigstens einen integrierten Schaltungschip enthält, der auf einer seiner Flächen eine metallische Verbindungsschicht mit Verbindungen und Kontaktflächen, eine isolierende Passivierungsschicht mit Öffnungen über den Kontaktflächen und einen dünnen Film aus einer elektrisch leitenden Substanz aufweist, der die Passivierungsschicht direkt bedeckt, mit wenigstens einer der Kontaktflächen in Kontakt steht und auf ein Versorgungspotential des Chips gebracht ist, dadurch gekennzeichnet, daß der Film eine Dicke in der Größenordnung von einigen Nanometern oder weniger hat, daß der Film mit der Gesamtheit der Kontaktflächen in Kontakt steht und daß der Film einen Widerstand in der Größenordnung von 10⁷ bis 10¹⁴ Ohm zwischen zwei Kontaktflächen des Chips aufweist.

2. Chipkarte gemaß Anspruch 1, dadurch gekennzeichnet, daß Verbindungsdrähte über den dazwischenliegenden Film an die Kontaktflächen des Chips angelötet sind und daß der Chip mit einer isolierenden Schutzschicht umhüllt ist.

3. Chipkarte nach einem der Ansprüche 1 oder 2, dadurch gekennzeichnet, daß in dem Fall, daß die Karte mit kontaktloser Energie- oder Informationsübertragung arbeitet, der Film Antennenelemente für die Sendung oder den Empfang elektromagnetischer Wellen nicht bedeckt.
